# EUROPÄISCHE PATENTSCHRIFT

(11) **EP 3 379 577 B1**
(45) Veröffentlichungstag und Bekanntmachung des Hinweises auf die Patenterteilung: **03.06.2020**
(21) Anmeldenummer: 18000269.3
(22) Anmeldetag: 19.03.2018
(51) Int. Cl.: H01L 29/32, H01L 29/861, H01L 29/20

(54) **III-V-HALBLEITERDIODE AUF GAAS BASIS**
GAAS-BASED III-V SEMICONDUCTOR DIODE
DIODE SEMI-CONDUCTRICE III-V À BASE DE GAAS

(30) Priorität: 24.03.2017 DE 102017002935
(43) Veröffentlichungstag der Anmeldung: 26.09.2018
(73) Patentinhaber: 3-5 Power Electronics GmbH, 01217 Dresden (DE)
(72) Erfinder: Dudek, Volker, 76275 Ettlingen (DE)
(74) Vertreter: Koch Müller Patentanwaltsgesellschaft mbH

(56) Entgegenhaltungen:
- WO-A1-2013/028973
- US-A- 5 733 815
- US-A1- 2006 281 263
- KOZLOV V A ET AL: "Defect engineering for carrier lifetime control in high voltage GaAs power diodes", 25TH ANNUAL SEMI ADVANCED SEMICONDUCTOR MANUFACTURING CONFERENCE (ASMC 2014), IEEE, 19. Mai 2014 (2014-05-19), Seiten 139-144, XP032614174, DOI: 10.1109/ASMC.2014.6847011 [gefunden am 2014-06-30]
- G Ashkinaw ET AL: "PROCESS AND DEVICE CHARACTERIZATION OF HIGH VOLTAGE GALLIUM ARSENIDE P-i-N LAYERS GROWN BY AN IMPROVED LIQUID PHASE EPITAXY METHOD", , 1. Januar 1993 (1993-01-01), Seiten 1749-1755, XP055498521, Gefunden im Internet: URL:https://ac.els-cdn.com/003811019390222 C/1-s2.0-003811019390222C-main.pdf?_tid=72 33ad54-efe8-4ea2-88c8-5e338494f1ea&acdnat= 1533743034_2745cb1569513a6a36b78720a87bc23 6
- TOM SIMON ET AL: "Gallium arsenide semiconductor parameters extracted from pin diode measurements and simulations", IET POWER ELECTRONICS, Bd. 9, Nr. 4, 30. März 2016 (2016-03-30), Seiten 689-697, XP055498441, UK ISSN: 1755-4535, DOI: 10.1049/iet-pel.2015.0019
- A. KOEL: "Characterization of the temperature dependent behavior of snappy phenomenon by the switching-off of GaAs power diode structures", ADVANCES IN FLUID MECHANICS XI, vol. 1, July 2014 (2014-07), pages 439-449, XP055545469, Southampton UK ISSN: 1746-4471, DOI: 10.2495/HT140381 ISBN: 978-1-78466-105-2
- VIKTOR VOITOVICH ET AL: "LPE technology for power GaAs diode structures", ESTONIAN JOURNAL OF ENGINEERING, vol. 16, no. 1, January 2010 (2010-01), pages 11-22, XP055498749, DOI: 10.3176/eng.2010.1.04

## Beschreibung

Die Erfindung betrifft eine III-V-Halbleiterdiode.

Aus "GaAs Power Devices" von German Ashkinazi, ISBN 965-7094-19-4, Seite 8 und 9 ist eine hochspannungsfeste Halbleiterdiode p⁺ - n - n⁺ bekannt. Es ist wünschenswert, dass hochspannungsfeste Halbleiterdioden neben der hohen Spannungsfestigkeit sowohl niedrige Durchschaltwiderstände als auch geringe Leckströme im Sperrbereich aufweisen.

Die US 5,733,815 beschreibt ein Herstellungsverfahren für intrinsische Schicht für III-V-Halbleiterbauelemente. Aus der US 2006/0281263 A1 sind Siliziumbasierte Bauelemente mit einer Defektschicht innerhalb einer intrinsischen Schicht bekannt. GaAs wird als alternatives Halbleitermaterial erwähnt. Weitere Waferstrukturen auf Silizium-Basis sind aus der WO 2013/028973 A1 bekannt.

Aus A.Koel: "Characterization of the temperature dependent behavior of snappy phenomenon by the switching-off of GaAs power diode structures", Adavances in Fluid Mechanics XI, Bd. 1, 1. Juli 2014, Seiten 439-449, Southampton UK ISSN: 1746-4471, ISBN: 978-1-78466-105-2 sowie aus V. Voitovich et al.: "LPE technology for power GaAs diode structures", Estonian Journal of Engineering sind GaAs-Diodenstrukturen bekannt.

Das Paper von Koel beschreibt eine GaAs Leistungsdiode, die ein p⁺-dotiertes Substrat, eine p-dotierte Schicht, eine niedrig n-dotierte Schicht, eine n-dotierte Schicht und eine n⁺-dotierte Schicht umfasst. Die GaAs Schichten werden übereinander mittels LPE epitaktisch gewachsen.

Vor diesem Hintergrund besteht die Aufgabe der Erfindung darin, eine Vorrichtung anzugeben, die den Stand der Technik weiterbildet.

Die Aufgabe wird durch eine III-V-Halbleiterdiode mit den Merkmalen des Patentanspruchs 1 gelöst. Vorteilhafte Ausgestaltungen der Erfindung sind Gegenstand von Unteransprüchen.

Die stapelförmige III-V-Halbleiterdiode umfasst erfindungsgemäß eine erste Defektschicht. Die erste Defektschicht weist eine Schichtdicke zwischen 0,5 µm und 30 µm auf, wobei die Defektschicht innerhalb der n⁻-Schicht angeordnet ist und die Defektschicht eine Defektkonzentration im einem Bereich zwischen 1•10¹⁴ N/ cm³ und 5•10¹⁷ N/cm³ aufweist.

Es sei angemerkt, dass die Schichten mittels einer Flüssigphasenepitaxie oder mittels einer MOVPE Anlage hergestellt werden.

Es versteht sich, dass die Defektschicht sich auf unterschiedliche Welse, beispielsweise durch Implantation oder mittels Einbau von Fremdatomen erzeugen lässt und innerhalb der Defektschicht eine Rekombination von Ladungsträger erreicht wird.

Auch sei angemerkt, dass die Defektschicht möglichst nicht innerhalb der Raumladungszone ausgebildet ist. Vorzugsweise ist die Dicke der n⁻-Schicht derart ausgebildet, so dass die Defektschicht von der Raumladungszone beabstandet ist.

Ein Vorteil ist, dass sich mittels des Einbaus der Defektschicht die Höhe der Leckströme im Sperrbereich reduzieren lässt, während im Durchlassbereich sich die Bauelementeeigenschaften nahezu unbeeinflusst sind. Insbesondere im Sperrbereich bei Spannung oberhalb 1000V machen sich Leckströme nachteilig bemerkbar.

Ferner steigen die Leckströme mit der Temperatur stark an. Durch den Einbau der Defektschicht lassen sich die Leckströme um mehr als eine Größenordnung gegenüber Dioden ohne Defektschicht reduzieren. Des Weiteren wird der Herstellungsprozess wesentlich robuster, d.h. unempfindlich gegen eine hohe Hintergrunddotierung.

Ein weiterer Vorteil ist, dass sich mit der erfindungsgemäßen III-V-Halbleiterdiode auf einfache Weise niedrige Leckströme bei Sperrspannungen in einem Bereich von 200V - 3300 V mit kleineren Einschaltwiderständen und geringeren Kapazitäten pro Fläche als herkömmliche hochsperrende Dioden aus Si oder aus SiC herstellen lassen. Hierdurch sind Schaltfrequenzen von 30 kHz bis zu 0,5 GHz und Stromdichten von 0,5 A/mm² bis 5 A/mm² erreichbar.

Ein anderer Vorteil ist, dass sich die III-V-Halbleiterdioden kostengünstiger als vergleichbare hochsperrende Dioden aus SiC herstellen lassen.

Insbesondere lassen sich die erfindungsgemäßen III-V-Halbleiterdioden als Freilaufdioden verwenden.

Es sei angemerkt, dass die erfindungsgemäßen III-V-Halbleiterdioden vorliegend kleine Einschaltwiderstände in einem Bereich zwischen 1 mOhm und 200 mOhm aufweisen. Die Kapazitäten pro Fläche liegen in einem Bereich zwischen 2 pF und 100 pF.

Ein anderer Vorteil der erfindungsgemäßen III-V-Halbleiterdiode ist eine hohe Temperaturfestigkeit von bis zu 300°C. Anders ausgedrückt lassen sich die III-V-Halbleiterdioden auch in heißen Umgebungen einsetzten. Hierbei sind niedrige Leckströme aufgrund des exponentiellen Anstiegs mit steigender Temperatur besonders hilfreich.

Gemäß einer Weiterbildung weist die Halbleiterdiode eine zweite Defektschicht auf, wobei die zweite Defektschicht eine Schichtdicke in einem Bereich zwischen 0,5 µm und 50 µm und eine Defektkonzentration Im einem Bereich zwischen 1•10¹³N/ cm³ und 5•10¹⁶ N/cm³ aufweist und einen Abstand zu der Oberseite der n⁻-Schicht von höchstens der Hälfte der Schichtdicke der n⁻-Schicht aufweist. Vorzugsweise unterscheidet sich die Defektkonzentration der ersten Defektschicht von der zweiten Defektschicht.

In einer weiteren Ausführungsform weist die erste Defektschicht und/oder eine zweite Defektschicht mindestens einen ersten Schichtbereich mit einer ersten Defektkonzentration und einen zweiten Schichtbereich mit einer zweiten Defektkonzentration auf und folgt insbesondere über die Schichtdicke der ersten Defektschicht und/oder einer zweiten Defektschicht einer statistischen vorzugsweise Gauß-Verteilung. Anders ausgedrückt ist die Defektkonzentration entlang der Dicke der Defektschicht unterschiedlich.

Gemäß einer anderen Ausführungsform umfassen die erste Defektschicht und / oder die zweite Defektschicht Cr und/oder Indium und/oder Aluminium. Vorzugsweise wird Cr während des Epitaxieprozesses in die n⁻-Schicht eingebaut. Ein Vorteil des Einbaus von Cr ist, dass mittels der Konzentration von Cr sich die Anzahl der Störstellen und hierdurch die Anzahl der Rekombinationszentren kostengünstig und auf einfache Weise einstellen lässt, ohne dass der Epitaxieprozess unterbrochen wird.

In einer anderen Ausführungsform sind in der ersten Defektschicht und / oder In der zweiten Defektschicht die Störstellen durch eine Implantation von Atomen oder Molekülen oder durch eine Elektronenstrahl-Bestrahlung erzeugt. Vorzugsweise wird zur Erzeugung von Störstellen H₂ Moleküle mit der entsprechenden Energie und Dosis verwendet.

In einer anderen Weiterbildung weist die III-V-Halbleiterdiode eine n-dotierte oder p-dotierte Zwischenschicht mit einer Schichtdicke von 1 µm - 50 µm und einer Dotierstoffkonzentration von 10¹²-10¹⁷ N/cm³ auf, wobei die Zwischenschicht mit der p⁺-Schicht sowie mit der n⁻-Schicht stoffschlüssig verbunden ist.

Gemäß einer weiteren Ausführungsform beträgt eine Gesamthöhe des stapelförmigen Schichtaufbaus bestehend aus der p⁺-Schicht, der n⁻-Schicht und der n⁺-Schicht zwischen 150-800 µm.

Gemäß alternativer Ausführungsformen weist der stapelförmige Schichtaufbau bestehend aus der p⁺-Schicht, der n⁻-Schicht und der n⁺-Schicht eine rechteckige oder quadratische Oberfläche mit Kantenlängen zwischen 1 mm und 10 mm oder eine runde, vorzugsweise ovale oder kreisförmige Oberfläche auf.

Gemäß einer nicht erfindungsgemäßen Ausführungsform ist die p⁺-Schicht der Halbleiterdiode durch eine Anschlusskontaktschicht ersetzt, wobei die Anschlusskontaktschicht ein Metall oder eine metallische Verbindung umfasst oder aus einem Metall oder einer metallischen Verbindung besteht und einen Schottky-Kontakt ausbildet.

In einer anderen nicht erfindungsgemäßen Ausführungsform umfasst die III-V Halbleiterdiode wenigstens einen Halbleiterbond.

Es wird angemerkt, dass der Ausdruck Halbleiterbond synonym mit dem Ausdruck Waferbond verwendet wird.

In einer weiteren nicht erfindungsgemäßen Ausführungsform ist der Halbleiterbond bei dem stapelförmigen Schichtaufbau, bestehend aus dem p⁺-Substrat, der n⁻-Schicht und der n⁺-Schicht, zwischen der n⁻-Schicht und dem p⁺-Substrat ausgebildet.

In einer nicht erfindungsgemäßen Ausführungsform bildet der Schichtaufbau bestehend aus einem p⁺-Substrat einen ersten Teilstapel und der Schichtaufbau bestehend aus der n⁺-Schicht, der n⁻-Schicht einen zweiten Teilstapel.

In einer nicht erfindungsgemäßen Weiterbildung umfasst der stapelförmige Schichtaufbau eine zwischen dem p⁺-Substrat und der n⁻-Schicht angeordnete Zwischenschicht auf. Hierbei umfasst der erste Teilstapel die Zwischenschicht. Der Halbleiterbond ist zwischen der Zwischenschicht und der n⁻-Schicht angeordnet.

In einer nicht erfindungsgemäßen Weiterbildung wird der erste Teilstapel gebildet, in dem ausgehend von einem p⁺-Substrat mittels Epitaxie die Zwischenschicht hergestellt wird.

Vorzugsweise weist die als p⁻-Schicht ausgebildete Zwischenschicht eine Dotierung kleiner als 10¹³ N/cm⁻³ oder eine Dotierung zwischen 10¹³ N/cm⁻³ und 10¹⁵ N/cm⁻³ auf. In einer nicht erfindungsgemäßen Ausführungsform wird das p⁺-Substrat vor oder nach dem Bonden durch einen Schleifprozess auf eine Dicke zwischen 200 µm und 500 µm gedünnt.

In einer nicht erfindungsgemäßen Weiterbildung sind der erste Teilstapel und der zweite Teilstapel jeweils monolithisch ausgebildet.

In einer nicht erfindungsgemäßen Ausführungsform wird der zweite Stapel gebildet, in dem ausgehend von einem n⁻-Substrat, das n⁻-Substrat mit dem zweiten Stapel durch einen weiteren Waferbondprozess verbunden wird.

In einem weiteren Prozessschritt wird das n⁻-Substrat auf die gewünschte Dicke gedünnt. Vorzugsweise liegt die Dicke des n⁻-Substrats in einem Bereich zwischen 50 µm bis 250µm. Vorzugsweise liegt die Dotierung des n⁻-Ein Vorteil des Waferbondens ist es, dass sich dicke n⁻-Schichten ohne weiteres herstellen lassen. Ein langer Abscheideprozess bei der Epitaxie entfällt hierdurch. Auch lassen sich mittels des Bondens die Anzahl der Stapelfehler bei den dicken n⁻-Schichten verringern.

In einer anderen nicht erfindungsgemäßen Weiterbildung wird vor dem Bonden die Defektschicht vorzugsweise mittels Implantation von Ionen In die Oberfläche des zweiten Teilstapels erzeugt.

In eine alternativen nicht erfindungsgemäßen Ausführungsform weist das n⁻-Substrat eine Dotierung größer als 10¹⁰ N/cm⁻³ und kleiner als 10¹³ N/cm⁻³ auf. In dem die Dotierung extrem gering ist, lässt sich das n⁻-Substrat auch als eine intrinsische Schicht auffassen.

In einer nicht erfindungsgemäßen Weiterbildung wird nach dem Dünnen des n⁻-Substrats mittels Epitaxie oder Hochdosisimplantation auf dem n⁻-Substrat die n⁺-Schicht in einem Bereich zwischen 10¹⁸ N/cm⁻³ und kleiner als 5x10¹⁹ N/cm⁻³ erzeugt.

Es versteht sich, dass das Dünnen des n⁻-Substrats vorzugsweise mittels eines CMP Schrittes, d.h. mittels chemischen mechanischen Polierens erfolgt.

In einer nicht erfindungsgemäßen anderen Weiterbildung wird auf der Vorderseite der Dioden-Struktur eine Hilfsschicht aufgetragen. Anschließend lässt die Rückseite der Dioden-Struktur dünnen und auf einem Träger ablegen. In einer anderen nicht erfindungsgemäßen Weiterbildung wird anschließend die Hilfsschicht von der Vorderseite abgelöst.

In einer nicht erfindungsgemäßen Ausführungsform werden die Oberfläche des n⁺-Substrats und die Oberfläche des p⁺-Substrats metallisiert, um die Halbleiter-Diode elektrisch anzuschließen. Vorzugsweise wird die Kathode der Halbleiter-Diode nach der Metallisierung mit einer als Wärmesenke ausgebildeten Unterlage stoffschlüssig verbunden. Anders ausgedrückt, die Anode ist an der Oberfläche der Diode auf der p+-Schicht ausgebildet.

Untersuchungen haben gezeigt, dass sich mit bestimmten Kombinationen von einer p⁻- Zwischenschicht und n⁻-Schicht verschiedene Sperrspannungen erzielen lassen.

In einer ersten Variante umfasst die:
p⁻- Zwischenschicht eine Dicke zwischen 10 µm bis 25 µm und für die n⁻-Schicht eine Dicke zwischen 40 µm und 90 µm eine Sperrspannung von ca. 900 V ergibt.

In einer zweiten Variante umfasst die:
p⁻- Zwischenschicht eine Dicke zwischen 25 µm bis 35 µm und für die n⁻-Schicht eine Dicke zwischen 40 µm und 70 µm eine Sperrspannung von ca. 1200 V ergibt.

In einer dritten Variante umfasst die:
p'- Zwischenschicht eine Dicke zwischen 35 µm bis 50 µm und für die n⁻-Schicht eine Dicke zwischen 70µm und 150 µm und 70 µm eine Sperrspannung von ca. 1500 V ergibt.

Die Dioden in der ersten bis dritten Variante lassen sich auch als Punsch- Dioden bezeichnen.

In einer vierten Variante umfasst die:
p⁻- Zwischenschicht eine Dicke zwischen 10 µm bis 25 µm und für die n⁻-Schicht eine Dicke zwischen 60 µm und 110 µm.

In einer fünften Variante umfasst die:
p⁻- Zwischenschicht eine Dicke zwischen 10 µm bis 25 µm und für die n⁻-Schicht eine Dicke zwischen 70 µm und 140.

In einer sechsten Variante umfasst die:
p⁻- Zwischenschicht eine Dicke zwischen 35 µm bis 50 µm und für die n⁻-Schicht eine Dicke zwischen 80µm und 200 µm.

Die Dioden in der vierten bis sechsten Variante lassen sich auch als "non - reach - through" - Dioden bezeichnen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die:
- Figur 1: eine Ansicht einer ersten erfindungsgemäße Ausführungsform einer III-V-Halbleiterdiode,
- Figur 2: eine Ansicht einer zweiten erfindungsgemäße Ausführungsform einer III-V-Halbleiterdiode,
- Figur 3: eine Aufsicht auf die III-V-Halbleiterdiode aus Figur 1 oder aus Figur 2,
- Figur 4: eine Ansicht einer dritte erfindungsgemäße Ausführungsform einer III-V-Halbleiterdiode,
- Figur 5: eine Ansicht einer vierte erfindungsgemäße Ausführungsform einer III-V-Halbleiterdiode,
- Figur 6: eine Ansicht einer fünfte erfindungsgemäße Ausführungsform einer III-V-Halbleiterdiode,
- Figur 7: eine Ansicht einer sechste erfindungsgemäße Ausführungsform einer III-V-Halbleiterdiode,
- Figur 8: eine Ansicht einer siebte erfindungsgemäße Ausführungsform einer III-V-Halbleiterdiode,
- Figur 9: eine Ansicht einer achte erfindungsgemäße Ausführungsform einer III-V-Halbleiterdiode,

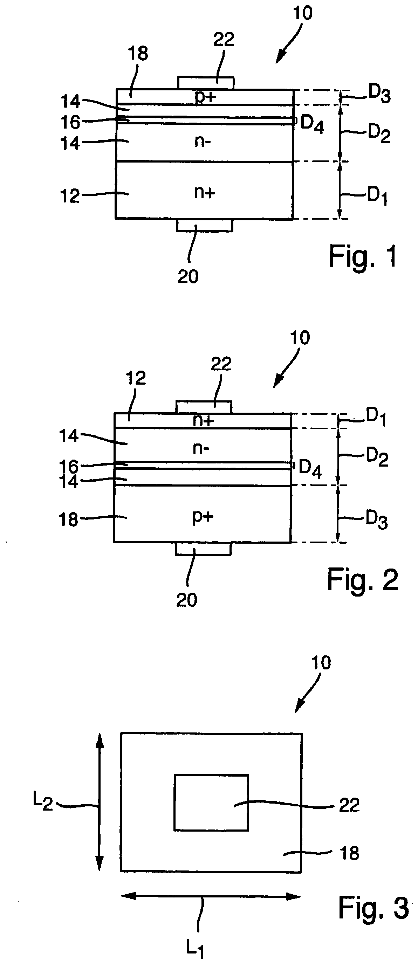

Die Abbildung der Figur 1 zeigt eine Ansicht einer ersten Ausführungsform einer erfindungsgemäßen stapelförmigen III-V-Halbleiterdiode 10, aufweisend eine n⁺-Schicht 12 als ein Substrat, eine mit der n⁺-Schicht 12 stoffschlüssig verbundene niedrig dotierte n⁻-Schicht 14 und eine mit der n⁻-Schicht 14 stoffschlüssig verbundene p⁺-Schicht 18 sowie einen ersten Kontakt 20 und einen zweiten Kontakt 22. Innerhalb der n⁻-Schicht 14 ist eine Defektschicht 16 angeordnet.

Der erste Kontakt 20 ist stoffschlüssig mit einer Unterseite der n⁺-Schicht 12 verbunden, während der zweite Kontakt 22 stoffschlüssig mit einer Oberseite der p⁺-Schicht 18 verbunden ist.

Die n⁺-Schicht 12 ist stark n-dotiert und weist eine Dotierstoffkonzentration von 10¹⁹ N/cm³. Eine Schichtdicke D1 der n⁺-Schicht 12 liegt zwischen 100 µm und 675 µm.

Die n⁻-Schicht 14 ist niedrig n-dotiert mit einer Dotierstoffkonzentration von 10¹²-10¹⁶ N/cm³ und weist eine Schichtdicke D2 von 10-300 µm auf.

Die p⁺-Schicht 18 ist stark p-dotiert mit einer Dotierstoffkonzentration von 10¹⁹ N/cm³ und einer Schichtdicke D3 größer 2 µm.

Die Defektschicht 16 weist eine Schichtdicke D4 in einen Bereich zwischen 0,5 µm und 50 µm und eine Defektdichte im einem Bereich zwischen 1•10¹³ N/cm³ und 5•10¹⁶ N/cm³ auf.

In den Abbildungen der Figuren 2 ist eine zweite Ausführungsform einer III-V-Halbleiterdiode dargestellt, wobei der Unterschied zu der Abbildung der Figur 1 darin liegt, dass die p+-Schicht 18 als Substrat ausgebildet ist, auf das die weiteren Schichten folgen.

In der Abbildung der Figuren 3 ist eine Aufsicht auf die in Figur 1 gezeigte erste Ausführungsform einer erfindungsgemäßen III-V-Halbleiterdiode dargestellt. Im Folgenden werden nur die Unterschiede zu der Abbildung der Figur 1 erläutert.

Der stapelförmige Schichtaufbau 100 der III-V-Halbleiterdiode 10 bestehend aus dem n⁺-Substrat 12, der die Defektschicht 16 umfassenden n⁻-Schicht 14 und der p⁺-Schicht 18 weist einen rechteckigen Umfang und damit auch eine rechteckige Oberfläche mit den Kantenlängen L1 und L2 auf. Die auf der Oberfläche der Schichtenfolge 100 angeordnete Kontaktfläche 22 überdeckt nur einen Teil der Oberfläche.

In einer anderen nicht dargestellten Ausführungsform sind die Ecken des stapelförmigen Schichtaufbaus 100 verrundet, um Feldstärkespitzen bei hohen Spannungen zu vermeiden.

In einer anderen nicht dargestellten Ausführungsform ist die Oberfläche des stapelförmigen Schichtaufbaus 100 rund ausgeführt. Hierdurch werden Überhöhungen der Feldstärke besonders effektiv reduziert. Vorzugsweise ist die Oberfläche kreisförmig oder oval ausgeführt.

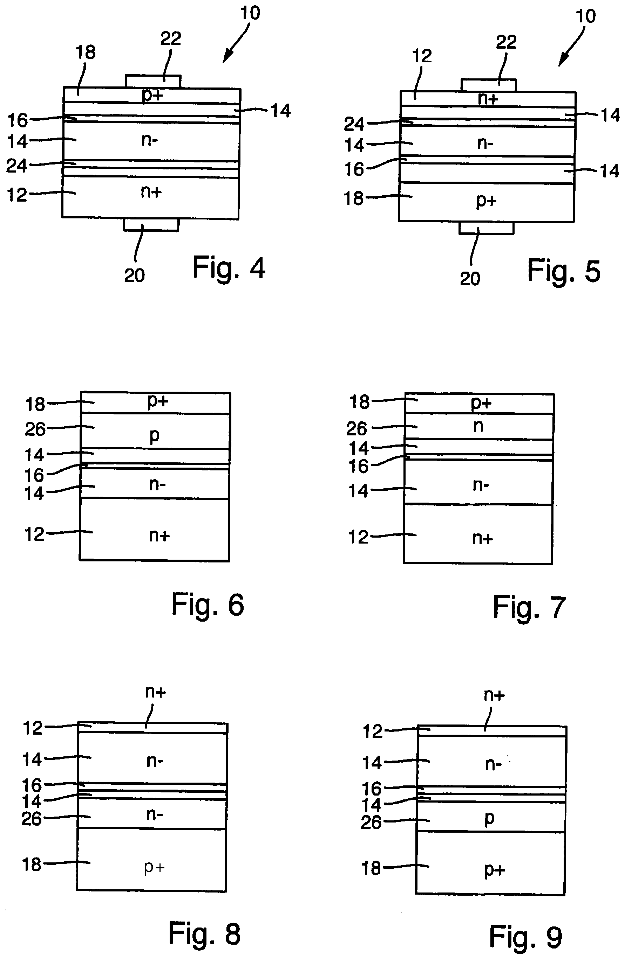

In der Abbildung der Figuren 4 ist eine Weiterbildung der III-V-Halbleiterdiode aus Figur 1 dargestellt, wobei die n⁻-Schicht 14 der Halbleiterdiode 10 im Unterschied zu der ersten Ausführungsform eine zweite Defektschicht 24 aufweist.

In der Abbildung der Figuren 5 ist eine Weiterbildung der III-V-Halbleiterdiode aus Figur 2 dargestellt, wobei die n⁻-Schicht 14 der Halbleiterdiode 10 im Unterschied zu der zweiten Ausführungsform eine zweite Defektschicht 24 aufweist.

In den Abbildungen der Figuren 6 und 7 sind zwei alternative Weiterbildungen der III-V-Halbleiterdiode aus Figur 1 dargestellt, wobei im Folgenden nur die Unterschiede zu der Figur 1 erläutert werden.

Die Halbleiterdiode weist gemäß einer ersten Ausführungsform eine niedrig p-dotierte Zwischenschicht 26 zwischen der n⁻-Schicht 14 und der p⁺-Schicht 18 auf, wie in Figur 6 dargestellt. Alternativ ist die Zwischenschicht 26 n-dotiert, wie in Figur 7 dargestellt.

In den Abbildungen der Figuren 8 und 9 sind zwei alternative Weiterbildungen der III-V-Halbleiterdiode aus Figur 2 dargestellt, wobei im Folgenden nur die Unterschiede zu der Figur 2 erläutert werden.

Die Halbleiterdiode weist gemäß einer ersten Ausführungsform eine niedrig p-dotierte Zwischenschicht 26 zwischen der n⁻-Schicht 14 und der p⁺-Schicht 18 auf, wie in Figur 9 dargestellt. Alternativ Ist die Zwischenschicht 26 n-dotiert, wie In Figur 8 dargestellt.

## Patentansprüche

1. Stapelförmige monolithische III-V-Halbleiterdiode (10), aufweisend
- eine n⁺-Schicht (12) mit einer ersten Seite und einer der ersten Seite gegenüberliegenden zweiten Seite wobei die n⁺-Schicht (12) eine GaAs-Verbindung umfasst oder aus einer GaAs Verbindung besteht
- eine n⁻-Schicht (14) mit einer ersten Seite und einer der ersten Seite gegenüberliegenden zweiten Seite, einer Dotierstoffkonzentration von 10¹²-10¹⁶ N/cm³, einer Schichtdicke (D2) von 10-300 µm, wobei die n⁻-Schicht (14) eine GaAs-Verbindung umfasst oder aus einer GaAs Verbindung besteht,
- eine p⁺-Schicht (18) mit einer ersten Seite und einer der ersten Seite gegenüberliegenden zweiten Seite, einer Dotierstoffkonzentration von 5•10¹⁸-5•10²⁰ N/cm³, mit einer Schichtdicke (D3) größer 2 µm,wobei die p⁺-Schicht (18) eine GaAs-Verbindung umfasst oder aus einer GaAs Verbindung besteht, wobei
- die Schichten in der genannten Reihenfolge aufeinander folgen und monolithisch ausgebildet sind,
- die zweite Seite der n⁻-Schicht (14) stoffschlüssig mit der ersten Seite der n⁺-Schicht (12) verbunden ist,
- die n⁺-Schicht (12), eine Dotierstoffkonzentration von mindestens 10¹⁹ N/cm³ und eine Schichtdicke (D1) von 10 µm - 675 µm aufweist,
- die n⁺-Schicht (12) oder die p⁺-Schicht (18) als Substrat ausgebildet ist,
- die stapelförmige III-V-Halbleiterdiode (10) eine erste Defektschicht (16) mit einer Schichtdicke (D4) zwischen 0,5 µm und 50 µm aufweist,
- wobei die erste Defektschicht (16) innerhalb der n⁻-Schicht angeordnet ist,
- die erste Defektschicht (16) eine Defektkonzentration in einem Bereich zwischen 10•10¹³ N/cm³ und 5•10¹⁶ N/cm³ aufweist, und
- die erste Defektschicht (16) einen Abstand (A) zu der Unterseite der n⁻
- Schicht (14) von mindestens der Hälfte der Schichtdicke (D2) der n⁻-Schicht (14) aufweist.

2. III-V-Halbleiterdiode (10) nach Anspruch 1, **dadurch gekennzeichnet, dass** die Halbleiterdiode (10) eine innerhalb der n⁻-Schicht (14) angeordnete zweite Defektschicht (24) aufweist, wobei die zweite Defektschicht (24) eine Schichtdicke zwischen 0,5 µm und 50 µm und eine Defektkonzentration zwischen 1•10¹³ N/cm³ und 5•10¹⁶ N/cm³ aufweist und einen Abstand zu der Oberseite der n⁻-Schicht (14) von höchstens die Hälfte der Schichtdicke (D2) der n⁻-Schicht (14) aufweist.

3. III-V-Halbleiterdiode (10) nach einem der Ansprüche 1 bis 2, **dadurch gekennzeichnet, dass** die erste Defektschicht (16) einen ersten Schichtbereich mit einer ersten Defektkonzentration und einen zweiten Schichtbereich mit einer zweiten Defektkonzentration aufweist.

4. III-V-Halbleiterdiode (10) nach einem der Ansprüche 1 bis 3, **dadurch gekennzeichnet, dass** die Defektkonzentration über die Schichtdicke (D4) der ersten Defektschicht (16) einer statistischen-Verteilung folgt.

5. III-V-Halbleiterdiode (10) nach einem der Ansprüche 1 bis 4, **dadurch gekennzeichnet, dass** die erste Defektschicht (16) Cr und/oder Indium und/oder Aluminium umfasst

6. III-V-Halbleiterdiode (10) nach Anspruch 2, **dadurch gekennzeichnet, dass** die zweite Defektschicht (24) Cr und/oder Indium und/oder Aluminium umfasst und/oder die zweite Defektschicht (24) einen ersten Schichtbereich mit einer ersten Defektkonzentration und einen zweiten Schichtbereich mit einer zweiten Defektkonzentration aufweist und/oder die Defektkonzentration der zweiten Defektschicht (24) über die Schichtdicke der zweiten Defektschicht (24) einer statistischen-Verteilung folgt.

7. III-V-Halbleiterdiode (10) nach einem der Ansprüche 1 bis 6, **dadurch gekennzeichnet, dass** die III-V-Halbleiterdiode eine n-dotierte oder p-dotierte Zwischenschicht (26) mit einer Schichtdicke von 1 µm - 50 µm und einer Dotierstoffkonzentration von 10¹²-10¹⁷ N/cm³ aufweist, wobei die Zwischenschicht mit der p⁺-Schicht (18) sowie mit der n⁻-Schicht (14) stoffschlüssig verbunden ist.

8. III-V-Halbleiterdiode (10) nach einem der Ansprüche 1 bis 6, **dadurch gekennzeichnet, dass** eine Gesamthöhe eines stapelförmigen Schichtaufbaus (100) bestehend aus dem p⁺-Schicht (18), der n⁻-Schicht (14) und der n⁺-Schicht (12) höchstens 150-800 µm beträgt.

9. III-V- Halbleiterdiode (10) nach einem der Ansprüche 1 bis 6 oder 8, **dadurch gekennzeichnet, dass** der stapelförmige Schichtaufbau (100) bestehend aus dem p⁺-Schicht (18), der n⁻-Schicht (14), und der n⁺-Schicht (12) eine rechteckige oder quadratische Oberfläche mit Kantenlängen (L1, L2) zwischen 1 mm und 10 mm aufweist.

10. III-V- Halbleiterdiode (10) nach einem der Ansprüche 1 bis 6 oder 8 bis 9, **dadurch gekennzeichnet, dass** der stapelförmige Schichtaufbau (100) bestehend aus dem p⁺-Schicht (18), der n⁻-Schicht (14), der n⁺-Schicht (12) eine runde oder ovale oder kreisförmige Oberfläche aufweist.

## Claims

1. Stack-shaped monolithic lll-V semiconductor diode (10), comprising
- an n⁺ layer (12) with a first side and a second side opposite the first side, wherein the n⁺ layer (12) comprises a GaAs compound or consists of a GaAs compound,
- an n- layer (14) with a first side and a second side opposite the first side, a doping substance concentration of 10¹² - 10¹⁶ N/cm³, a layer thickness (D2) of 10 - 300 µm, wherein the n⁻ layer (14) comprises a GaAs compound or consists of a GaAs compound,
- a p⁺ layer (18) with a first side and a second side opposite the first side, a doping substance concentration of 5 • 10¹⁸ - 5 • 10²⁰ N/cm³, with a layer thickness (D3) greater than 2 µm, wherein the p⁺ layer (18) comprises a GaAs compound or consists of a GaAs compound, wherein
- the layers follow one another in the stated sequence and are of monolithic construction,
- the second side of the n⁻ layer (14) is connected with the first side of the n⁺ layer (12) by material couple,
- the n⁺ layer (12) has a doping concentration of at least 10¹⁹ N/cm³ and a layer thickness (D1) of 10 µm - 675 µm,
- the n⁺ layer (12) or the p⁺ layer (18) is constructed as a substrate,
- the stack-shaped III-V semiconductor diode (10) comprises a first defect layer (16) with a layer thickness (D4) between 0.5 µm and 50µm,
- wherein the first defect layer (16) is arranged within the n⁻ layer,
- the first defect layer (16) has a defect concentration in a range between 1 • 10¹³ N/cm³ and 5 • 10¹⁶ N/cm³ and
- the first defect layer (16) has a spacing (A) from the lower side of the n⁻ layer (14) of at least half the layer thickness (D2) of the n⁻ layer (14).

2. III-V semiconductor diode (10) according to claim 1, **characterised in that** the semiconductor diode (10) comprises a second defect layer (24) arranged within the n⁻ layer (14), wherein the second defect layer (24) has a layer thickness between 0.5 µm and 50 µm and a defect concentration between 1 • 10¹³ N/cm³ and 5 • 10¹⁶ N/cm³ and a spacing from the upper side of the n⁻ layer (14) of at most half the layer thickness (D2) of the n⁻ layer (14).

3. III-V semiconductor diode (10) according to one of claims 1 and 2, **characterised in that** the first defect layer (16) has a first layer region with a first defect concentration and a second layer region with a second defect concentration.

4. III-V semiconductor diode (10) according to any one of claims 1 to 3, **characterised in that** the defect concentration over the layer thickness (D4) of the first defect layer (16) follows a statistical distribution.

5. III-V semiconductor diode (10) according to any one of claims 1 to 4, **characterised in that** the first defect layer (16) comprises Cr and/or indium and/or aluminium.

6. III-V semiconductor diode (10) according to claim 2, **characterised in that** the second defect layer (24) comprises Cr and/or indium and/or aluminium and/or the second defect layer (24) has a first layer region with a first defect concentration and a second layer region with a second defect concentration and/or the defect concentration of the second defect layer (24) over the layer thickness of the second defect layer (24) follows a statistical distribution.

7. III-V semiconductor diode (10) according to any one of claims 1 to 6, **characterised in that** the III-V semiconductor diode comprises an n-doped or p-doped intermediate layer (26) with a layer thickness of 1 µm - 50 µm and has a doping concentration of 10¹² - 10¹⁷ N/cm³, wherein the intermediate layer is connected with the p⁺ layer (18) and with the n⁻ layer (14) by material couple.

8. III-V semiconductor diode (10) according to any one of claims 1 to 6, **characterised in that** an overall height of a stack-shaped layer construction (100) consisting of the p⁺ layer (18), the n⁻ layer (14) and the n⁺ layer (12) is at most 150 - 800 µm.

9. III-V semiconductor diode (10) according to any one of claims 1 to 6 or claim 8, **characterised in that** the stack-shaped layer construction (100) consisting of the p⁺ layer (18), the n⁻ layer (14) and the n⁺ layer (12) has a rectangular or square surface with edge lengths (L1, L2) between 1 mm and 10 mm.

10. III-V semiconductor diode (10) according to any one of claims 1 to 6, 8 or 9, **characterised in that** the stack-shaped layer construction (100) consisting of the p⁺ layer (18), the n⁻ layer (14) and the n⁺ layer (12) has a round or oval or circular surface.

## Revendications

1. Diode semi-conductrice III-V monolithique à empilement (10), présentant:
une couche n⁺ (12), qui présente un premier côté et un second côté opposé au premier côté,
dans laquelle la couche n⁺ (12) comprend un composé GaAs ou se compose d'un composé GaAs,
une couche n- (14), qui présente un premier côté et un second côté opposé au premier côté, une concentration de dopant comprise entre 10¹²N/cm³ et 10¹⁶N/cm³ et une épaisseur de couche (D2) comprise entre 10 µm et 300 µm,
dans laquelle la couche n⁻ (14) comprend un composé GaAs ou se compose d'un composé GaAs,
une couche p⁺(18) qui présente un premier côté et un second côté opposé au premier côté, une concentration de dopant comprise entre 5.10¹⁸ N/cm³ et 5.10²⁰ N/cm³ avec une épaisseur de couche (D3) supérieure à 2 µm, dans laquelle la couche p⁺ (18) comprend un composé GaAs ou se compose d'un composé GaAs,
dans laquelle:
les couches se suivent dans l'ordre indiqué et sont formées de façon monolithique, le second côté de la couche n⁻ (14) est assemblé matériellement au premier côté de la couche n⁺ (12),
la couche n⁺ (12) présente une concentration de dopant d'au moins 10¹⁹ N/cm³ et une épaisseur de couche (D1) comprise entre 10 µm et 675 µm,
la couche n⁺ (12) ou la couche p⁺ (18) est réalisée comme un substrat,
la diode semi-conductrice III-V à empilement (10) présente une première couche de défaut (16) qui affiche une épaisseur de couche (D4) comprise entre 0,5 µm et 50 µm,
dans laquelle la première couche de défaut (16) est disposée à l'intérieur de la couche n⁻,
la première couche de défaut (16) présente une concentration de défauts comprise dans une plage de 1.10¹³ N/cm³ à 5.10¹⁶ N/cm³, et
la première couche de défaut (16) présente une distance (A) du côté inférieur de la couche n⁻ (14) qui est égale à au moins la moitié de l'épaisseur de couche (D2) de la couche n⁻ (14).

2. Diode semi-conductrice III-V (10) selon la revendication 1, **caractérisée en ce que** la diode semi-conductrice (10) présente une seconde couche de défaut (24) disposée à l'intérieur de la couche n⁻ (14), dans laquelle la seconde couche de défaut (24) présente une épaisseur de couche comprise entre 0,5 µm et 50 µm et une concentration de défauts comprise entre 1.10¹³ N/cm³ et 5.10¹⁶ N/cm³ et une distance du côté supérieur de la couche n⁻ (14) qui est égale au maximum à la moitié de l'épaisseur de couche (D2) de la couche n⁻ (14).

3. Diode semi-conductrice III-V (10) selon l'une quelconque des revendications 1 à 2, **caractérisée en ce que** la première couche de défauts (16) présente une première zone de couche qui affiche une première concentration de défauts et une seconde zone de couche qui affiche une seconde concentration de défauts.

4. Diode semi-conductrice III-V (10) selon l'une quelconque des revendications 1 à 3, **caractérisée en ce que** la concentration de défauts suit une distribution statistique sur l'épaisseur de couche (D4) de la première couche de défauts (16).

5. Diode semi-conductrice III-V (10) selon l'une quelconque des revendications 1 à 4, **caractérisée en ce que** la première couche de défauts (16) comprend du chrome et/ou de l'indium et/ou de l'aluminium.

6. Diode semi-conductrice III-V (10) selon la revendication 2, **caractérisée en ce que** la seconde couche de défauts (24) comprend du chrome et/ou de l'indium et/ou de l'aluminium, et/ou la seconde couche de défauts (24) présente une première zone de couche qui affiche une première concentration de défauts et une seconde zone de couche qui affiche une seconde concentration de défauts, et/ou la concentration de défauts de la seconde couche de défauts (24) suit une distribution statistique sur l'épaisseur de couche de la seconde couche de défauts (24).

7. Diode semi-conductrice III-V (10) selon l'une quelconque des revendications 1 à 6, **caractérisée en ce que** la diode semi-conductrice III-V présente une couche intermédiaire dopée n ou dopée p (26) qui affiche une épaisseur de couche comprise entre 1 µm et 50 µm et une concentration de dopant comprise entre 10¹² N/cm³ à 10¹⁷ N/cm³, dans laquelle la couche intermédiaire est assemblée matériellement à la couche p⁺ (18) et à la couche n⁻ (14).

8. Diode semi-conductrice III-V (10) selon l'une quelconque des revendications 1 à 6, **caractérisée en ce qu'**une hauteur totale de la structure de couches empilées (100), composée de la couche p⁺ (18), de la couche n⁻ (14), et de la couche n⁺ (12) vaut au plus de 150 µm à 800 µm.

9. Diode semi-conductrice III-V (10) selon l'une quelconque des revendications 1 à 6 ou 8, **caractérisée en ce que** la structure de couches empilées (100), composée de la couche p⁺ (18), de la couche n⁻ (14) et de la couche n⁺ (12), présente une surface rectangulaire ou carrée, avec des longueurs de côté (L1, L2) comprises entre 1 mm et 10 mm.

10. Diode semi-conductrice III-V. (10) selon l'une quelconque des revendications 1 à 6 ou 8 à 9, **caractérisée en ce que** la structure de couches empilées (100), composée de la couche p⁺ (18), de la couche n⁻ (14) et de la couche n⁺ (12), présente une surface ronde, ovale ou circulaire.
